# EUROPEAN PATENT APPLICATION

(11) **EP 4 213 210 A1**
(43) Date of publication of application: **19.07.2023**
(21) Application number: 22741413.3
(22) Date of filing: 24.02.2022
(51) Int. Cl.: H01L 27/108, H01L 21/8242

(54) **SEMICONDUCTOR STRUCTURE AND MANUFACTURING METHOD THEREFOR**

(30) Priority: 30.11.2021 CN 202111440983
(71) Applicant: Changxin Memory Technologies, Inc., Hefei City, Anhui 230000 (CN); Beijing Superstring Academy of Memory Technology, Beijing 100176 (CN)
(72) Inventor: XIAO, Deyuan, Hefei City, Anhui 230000 (CN); SHAO, Guangsu, Hefei City, Anhui 230000 (CN)
(74) Representative: Lavoix
(86) International application number: PCT/CN2022/077658
(87) International publication number: WO 2023/097901

(57) **Abstract**

The present disclosure provides a semiconductor structure and a manufacturing method thereof. The method of manufacturing a semiconductor structure includes: an array region, where the array region is provided with a plurality of active pillars; a plurality of bit lines extending along a first direction, where the bit line is located at a bottom of the active pillar; and a plurality of word lines extending along a second direction, where any one of the word lines covers sidewalls of a column of the active pillars arranged along the second direction; and the first direction and the second direction form a predetermined angle, and the predetermined angle is an acute angle or an obtuse angle.

## Description

### Cross-Reference to Related Applications

The present disclosure claims the priority to Chinese Patent Application 202111440983.7, titled "SEMICONDUCTOR STRUCTURE AND MANUFACTURING METHOD THEREOF", filed on November 30, 2021, which is incorporated herein by reference in its entirety.

### Technical Field

The present disclosure relates to, but is not limited to, a semiconductor structure and a manufacturing method thereof.

### Background

As one of the important components in an integrated circuit, the capacitor is widely used in the memory chip. At present, the integrated circuits develop to be more miniaturized, which requires the integrated circuits to have a higher integration density and a smaller feature size. In other words, it is required to dispose as many components as possible in a smaller-sized integrated circuit region to obtain higher performance.

### Summary

An overview of the subject described in detail in the present disclosure is provided below, which is not intended to limit the protection scope of the claims.

The present disclosure provides a semiconductor structure and a manufacturing method thereof.

A first aspect of the present disclosure provides a semiconductor structure, including:
an array region, where the array region is provided with a plurality of active pillars;
a plurality of bit lines extending along a first direction, where the bit lines are located at bottoms of the active pillars;
a plurality of word lines extending along a second direction, where any one of the plurality of word lines covers sidewalls of a column of the active pillars arranged along the second direction; and
the first direction and the second direction form a predetermined angle, and the predetermined angle is an acute angle or an obtuse angle.

According to some embodiments of the present disclosure, the active pillar is in a prismatic, cylindrical, or elliptical cylinder shape.

According to some embodiments of the present disclosure, the predetermined angle is 60° to 120°.

According to some embodiments of the present disclosure, the semiconductor structure further includes a plurality of capacitor structures, where each of the capacitor structures is correspondingly disposed above one of the active pillars, and projection formed by each of the capacitor structures on the active pillars covers a top surface of one of the active pillar.

According to some embodiments of the present disclosure, the semiconductor structure further includes:
an isolation structure, where the isolation structure fills gaps between adjacent active pillars, between adjacent word lines, between adjacent bit lines, between the word line and the bit line, and between the word line and the capacitor structure; and
a plurality of contact layers, where each of the contact layers covers a top surface of one of the active pillars, and the contact layers are disposed between the active pillars and the capacitor structures.

According to some embodiments of the present disclosure, the semiconductor structure further includes:
a core circuit region, where the core circuit region is located on a periphery of the array region;
the core circuit region is provided with a sense amplification circuit region, a plurality of sense amplifiers arranged along the second direction are disposed in the sense amplification circuit region, and the sense amplifier is connected to the bit line; and
the core circuit region is further provided with a word line driving circuit region, a plurality of word line drivers arranged along the first direction are disposed in the word line driving circuit region, and the word line driver is connected to the word line.

According to some embodiments of the present disclosure, the semiconductor structure further includes:
a peripheral circuit region, where the peripheral circuit region is located outside the core circuit region, a circuit or component in the peripheral circuit region is connected to a circuit or component in the core circuit region, and the peripheral circuit region has a contour extending along the first direction and the second direction.

A second aspect of the present disclosure provides a method of manufacturing a semiconductor structure, including:
providing a substrate;
performing first etching on the substrate, to form a plurality of first trenches that extend along a first direction and are disposed at intervals in a direction perpendicular to the first direction; and
performing second etching on the substrate, to form a plurality of second trenches that extend along a second direction and are disposed at intervals in a direction perpendicular to the second direction, where the first direction and the second direction form a predetermined angle, and the predetermined angle is an acute angle or an obtuse angle; and
the first trenches and the second trenches are interspersed to form a plurality of discrete active pillars, and a spacing between adjacent active pillars in the first direction is equal to a spacing between adjacent active pillars in a second direction.

According to some embodiments of the present disclosure, the first trench is deeper than the second trench.

According to some embodiments of the present disclosure, the method further includes:
forming a plurality of bit lines in the first trenches, where the bit lines extend along the first direction, and top surfaces of the bit lines are lower than bottom surfaces of the second trenches; and
forming a first isolation layer, where the first isolation layer covers the bit lines and fills gaps between adjacent bit lines, a part of each of the first trenches, and a part of each of the second trenches.

According to some embodiments of the present disclosure, the method further includes:
forming a gate oxide layer, where the gate oxide layer covers exposed sidewalls of the active pillars;
forming a plurality of word lines, where the word lines extend along an extension direction of the second trenches, and the word lines cover a part of the gate oxide layer and fill a partial structure of the first trench between two adjacent ones of the active pillars; and
forming a second isolation layer, where the second isolation layer fills gaps between adjacent word lines, and unfilled regions of the first trenches and the second trenches.

According to some embodiments of the present disclosure, the method further includes:
forming a plurality of contact layers, where each of the contact layers covers a top surface of one of the active pillars.

According to some embodiments of the present disclosure, the method further includes:
forming a plurality of capacitor structures at a top of the active pillars, where projection formed by each of the capacitor structures on the substrate covers projection formed by one of the active pillars on the substrate.

According to some embodiments of the present disclosure, the active pillar is in a prismatic shape, and the method further includes:
oxidizing the active pillar, such that the active pillar changes from the prismatic shape to a cylindrical or elliptical cylinder shape.

According to some embodiments of the present disclosure, the method further includes:
forming a core circuit region, where the core circuit region includes a sense amplification circuit region and a word line driving circuit region;
where, a plurality of sense amplifiers arranged along the second direction are disposed in the sense amplification circuit region, and the sense amplifier is connected to the bit line; and
a plurality of word line drivers arranged along the first direction are disposed in the word line driving circuit region, and the word line driver is connected to the word line.

According to some embodiments of the present disclosure, the method further includes:
forming a peripheral circuit region outside the core circuit region, where the peripheral circuit region has a contour extending along the first direction and the second direction; and
a circuit or component in the peripheral circuit region is electrically connected to a circuit or component in the core circuit region.

Other aspects of the present disclosure are understandable upon reading and understanding of the accompanying drawings and detailed description.

### Brief Description of the Drawings

The accompanying drawings incorporated into the specification and constituting a part of the specification illustrate the embodiments of the present disclosure, and are used together with the description to explain the principles of the embodiments of the present disclosure. In these accompanying drawings, similar reference numerals are used to represent similar elements. The accompanying drawings in the following description are some rather than all of the embodiments of the present disclosure. Those skilled in the art may obtain other accompanying drawings based on these accompanying drawings without creative efforts.
FIG. 1 is a schematic diagram of a semiconductor structure according to an exemplary embodiment;
FIG. 2 is a top view of the semiconductor structure according to an exemplary embodiment;
FIG. 3 is a top view of an array region of the semiconductor structure according to an exemplary embodiment;
FIG. 4 is a top view of the array region of the semiconductor structure according to an exemplary embodiment;
FIG. 5 is a schematic diagram of the semiconductor structure according to an exemplary embodiment;
FIG. 6 is a top view of the semiconductor structure according to an exemplary embodiment;
FIG. 7 is a schematic diagram of the semiconductor structure according to an exemplary embodiment;
FIG. 8 is a flowchart of a method of manufacturing a semiconductor structure according to an exemplary embodiment;
FIG. 9 is a flowchart of the method of manufacturing a semiconductor structure according to an exemplary embodiment;
FIG. 10 is a flowchart of a method of manufacturing a semiconductor structure according to an exemplary embodiment;
FIG. 11 is a schematic diagram of forming a first trench in a substrate according to an exemplary embodiment;
FIG. 12 is a schematic diagram of forming a second trench in the substrate according to an exemplary embodiment;
FIG. 13 is a top view of FIG. 12.
FIG. 14 is a top view of an oxidized active pillar according to an exemplary embodiment;
FIG. 15 is a schematic diagram of filling an isolation material in the first trench and the second trench according to an exemplary embodiment;
FIG. 16 is a cross-sectional view taken along A-A in FIG. 15;
FIG. 17 is a schematic diagram of removing a part of the isolation material in the first trench in the cross section taken along A-A in FIG. 15 according to an exemplary embodiment;
FIG. 18 is a schematic diagram of forming an initial bit line layer in the cross section taken along A-A in FIG. 15 according to an exemplary embodiment;
FIG. 19 is a schematic diagram of forming a first gap in the cross section taken along A-A in FIG. 15 according to an exemplary embodiment;
FIG. 20 is a schematic diagram in which the filled isolation material isolates adjacent bit lines according to an exemplary embodiment;
FIG. 21 is a schematic diagram of forming a first isolation layer according to an exemplary embodiment;
FIG. 22 is a top view of forming a gate oxide layer according to an exemplary embodiment;
FIG. 23 is a schematic diagram of forming an initial word line layer according to an exemplary embodiment;
FIG. 24 is a schematic diagram of forming a second gap according to an exemplary embodiment; and
FIG. 25 is a schematic diagram of forming a second isolation layer according to an exemplary embodiment.

### Reference numerals:

01, array region; 10, substrate; 11, first trench; 100, first structure; 111, first gap; 12, second trench; 20, active pillar; 200, second structure; 211, second gap; 40, bit line; 40a, bit line layer; 41, initial bit line layer; 50, word line; 50a, initial word line layer; 51, gate oxide layer; 60, isolation structure; 61, first isolation layer; 62, second isolation layer; 70, capacitor structure; 71, contact layer; 80, core circuit region; 81, sense amplification circuit region; 810, sense amplifier; 82, word line driving circuit region; 820, word line driver; 90, peripheral circuit region; 910, peripheral circuit; 920, peripheral electrical member; D1, first direction; D2, second direction; D3, third direction; and D4, fourth direction.

### Detailed Description

The technical solutions in the embodiments of the present disclosure are described below clearly and completely with reference to the accompanying drawings in the embodiments of the present disclosure. Apparently, the described embodiments are merely some rather than all of the embodiments of the present disclosure. All other embodiments obtained by those skilled in the art based on the embodiments of the present disclosure without creative efforts should fall within the protection scope of the present disclosure. It should be noted that the embodiments in the present disclosure and features in the embodiments may be combined with each other in a non-conflicting manner.

The semiconductor structure is not limited in this embodiment. The semiconductor structure is described below by taking a dynamic random access memory (DRAM) as an example, but this embodiment is not limited to this, and the semiconductor structure in this embodiment may further be another structure.

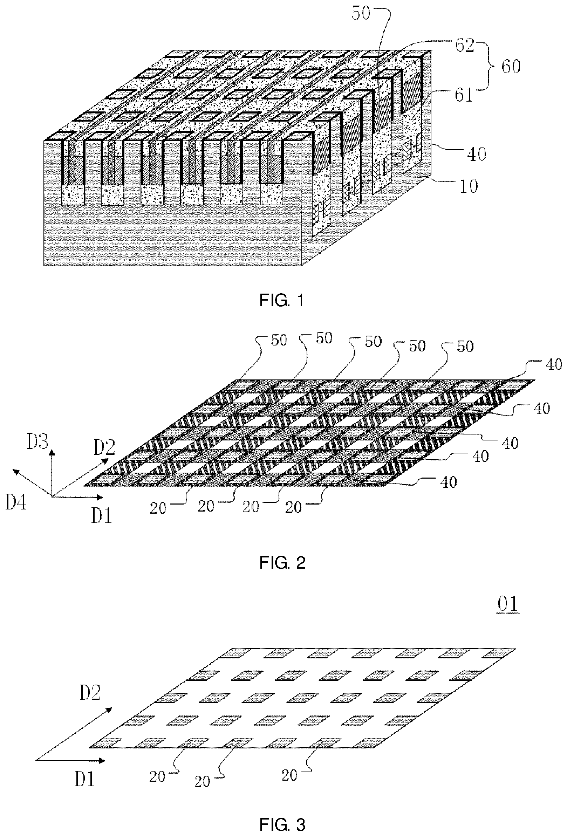

As shown in FIGS. 1 to 3, an exemplary embodiment of the present disclosure provides a semiconductor structure, including: an array region 01, a plurality of bit lines 40 extending along a first direction D1, and a plurality of word lines 50 extending along a second direction D2. The array region 01 is provided with a plurality of active pillars 20. The plurality of bit lines 40 are located at bottoms of the active pillars 20. Any one of the word lines 50 covers sidewalls of a column of the active pillars 20 arranged along the second direction D2. The plurality of word lines 50 correspondingly cover sidewalls of a plurality of columns of the active pillars 20 arranged along the second direction D2 respectively. The first direction D1 and the second direction D2 form a predetermined angle, and the predetermined angle is an acute angle or an obtuse angle.

In the semiconductor structure of this embodiment, the first direction D1 and the second direction D2 intersect to form an acute angle or an obtuse angle. The plurality of active pillars 20 are arranged in a parallelogram array along a non-orthogonal direction. A plurality of active pillars 20 are arranged in a plurality of rows along the first direction D1. A plurality of active pillars 20 are arranged in a plurality of columns along a second direction D2. The arrangement manner of the active pillars 20 in this embodiment improves the arrangement density of the active pillars 20 per unit area.

For example, the angle between the first direction D1 and the second direction D2 may be 30° to 70°, such as 30°, 35°, 45°, 55°, 65° or 70°, or may be 110° to 150° such as 110°, 120°, 130°, 140° or 150°. When the predetermined angle is 60° or 120°, a largest quantity of active pillars 20 are arranged in the array region 01, with a largest arrangement density.

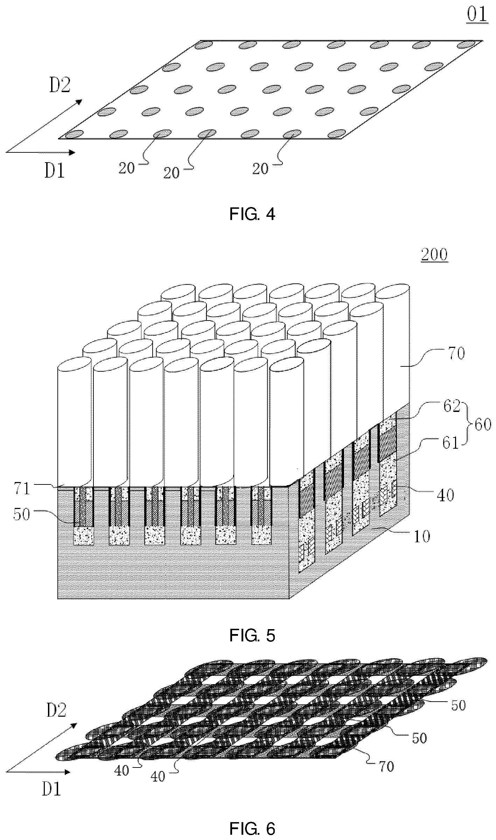

According to an exemplary embodiment, as shown in FIG. 3, the active pillar 20 is prismatic, and in FIG. 4, the active pillar 20 may further be cylindrical or elliptical.

According to an exemplary embodiment, as shown in FIGS. 5 and 6, the semiconductor structure further includes a plurality of capacitor structures 70, where each of the capacitor structures 70 is correspondingly disposed above one of the active pillars 20, and projection formed by each of the capacitor structures 70 on the active pillars 20 covers a top surface of one of the active pillars 20.

As shown in FIG. 6, any one of the bit lines 40 is connected to a row of the active pillars 20 arranged along a first direction D1. Any one of the word lines 50 covers sidewalls of a column of the active pillars 20 arranged along the second direction D2. The plurality of word lines 50 correspondingly cover sidewalls of a plurality of columns of the active pillars 20 arranged along the second direction D2 respectively. The bit line 40 and the word line 50 are staggered at the active pillar 20. The capacitor structure 70 is correspondingly disposed at an intersection of the bit line 40, the word line 50, and the active pillar 20.

In the semiconductor structure of this embodiment, the capacitor structures 70 are arranged in a parallelogram array according to the active pillars 20, to improve the space utilization of the semiconductor structure, such that more capacitor structures 70 can be disposed per unit area. In addition, in this embodiment, disposing more capacitor structures 70 further improves the charge storage capacity of the semiconductor structure.

According to an exemplary embodiment, as shown in FIG. 5, the semiconductor structure further includes: a plurality of contact layers 71. Each of the contact layers 71 covers a top surface of one of the active pillars 20. The contact layers 71 are disposed between the active pillars 20 and the capacitor structures 70. The contact layer 20 is configured to fix the capacitor structure 70 to the active pillar 20.

According to an exemplary embodiment, as shown in FIG. 1 or FIG. 5, the semiconductor structure further includes: an isolation structure 60, where the isolation structure 60 fills gaps between adjacent active pillars 20, between adjacent word lines 50, between adjacent bit lines 40, between the word line 50 and the bit line 40, and between the word line 50 and the capacitor structure 70.

In the semiconductor structure of this embodiment, an isolation structure 60 isolates a plurality of components in the semiconductor structure, to keep the components in the semiconductor structure independent, avoid a conductive interference between adjacent components, and prevent current leakage from occurring to the semiconductor structure, thereby enduring the electrical property of the semiconductor structure.

According to an exemplary embodiment, as shown in FIG. 1 or FIG. 5, top surfaces of the word lines 50 are lower than that of the active pillars 20. The isolation structure 60 covers the top surfaces of the word lines 50. The word lines 50 are integrally disposed in the semiconductor structure. Because adjacent word lines 50 are separated by the isolation structure 60, when the semiconductor structure is connected to another semiconductor member, the another semiconductor member is not directly connected to the word lines 50, to avoid that a direct connection between the another semiconductor member and the word lines 50 causes a short circuit of the word lines 50.

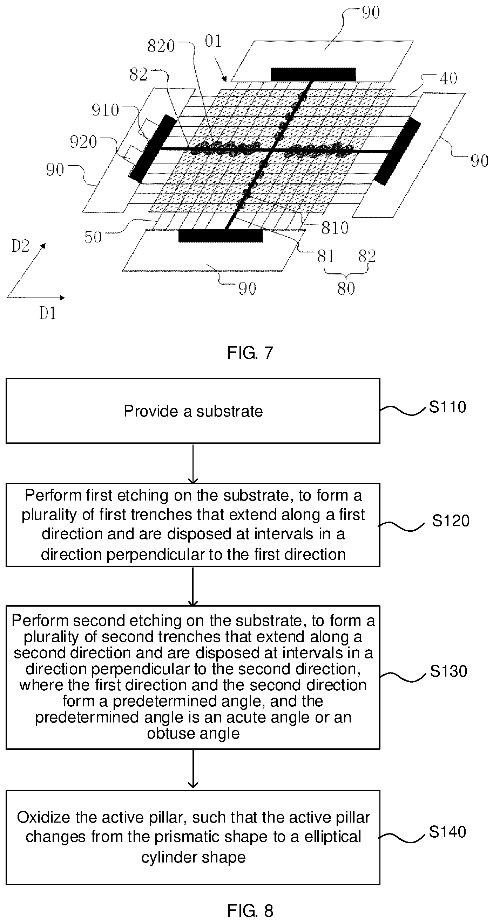

According to an exemplary embodiment, as shown in FIG. 7, the semiconductor structure of this embodiment further includes: a core circuit region 80 located on a periphery of the array region 01. The core circuit region 80 is provided with a sense amplification circuit region 81 and a word line driving circuit region 82. A plurality of sense amplifiers 810 arranged along the second direction D2 are disposed in the sense amplification circuit region 81, and the sense amplifier 810 is connected to the bit line 40; and a plurality of word line drivers 820 arranged along the first direction D1 are disposed in the word line driving circuit region 82, and the word line driver 820 is connected to the word line 50.

In this embodiment, the arrangement directions of the sense amplification circuit region 81 and the word line driving circuit region 82 in the core circuit region 80 are kept consistent with extension directions of the bit line 40 and the word line 50 respectively, to prevent the core circuit region 80 from damaging the active pillar 20 in the array region 01, and ensure the integrity of the semiconductor structure.

According to some embodiments of the present disclosure, as shown in FIG. 7, the semiconductor structure further includes a peripheral circuit region 90. The peripheral circuit region 90 has a contour extending along the first direction D1 and the second direction D2. The peripheral circuit region 90 is located outside the core circuit region 80. A peripheral circuit 910 and a peripheral electrical member 920 in the peripheral circuit region 90 are connected to a circuit and an electrical member in the core circuit region 80.

The peripheral circuit region and the array region of the semiconductor structure in this embodiment have a same parallelogram outline, which facilitates circuit design and wiring, ensures the structural integrity of each internal member in the semiconductor structure, such that the array region is completely used.

The semiconductor structure of this embodiment may be a memory chip, and the memory chip may be used in a DRAM. However, the memory structure may be further applied to a static random-access memory (SRAM), a flash memory (flash EPROM), a ferroelectric random-access memory (FRAM), a magnetic random-access memory (MRAM), a phase change random-access memory (PRAM), or the like.

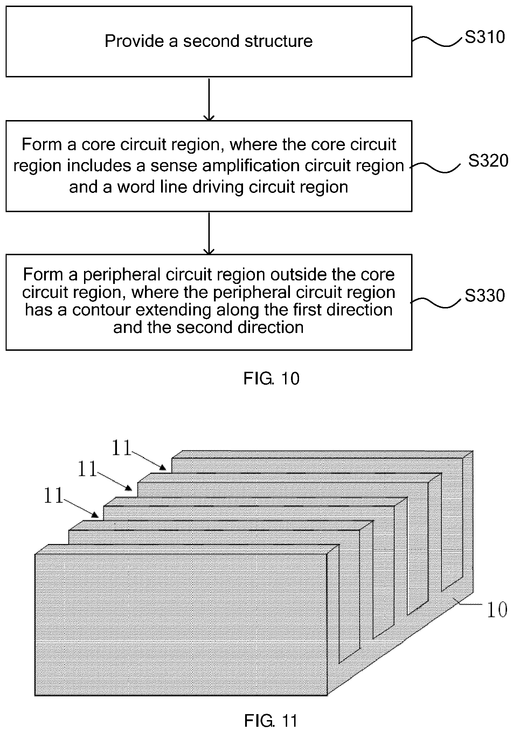

An exemplary embodiment of the present disclosure provides a method of manufacturing a semiconductor structure. FIG. 8 is a flowchart of the method of manufacturing a semiconductor structure according to an exemplary embodiment of the present disclosure. FIGS. 11 to 14 are schematic diagrams of the method of manufacturing a semiconductor structure at various stages. The method of manufacturing a semiconductor structure is described below with reference to FIGS. 11 to 14.

The semiconductor structure is not limited in this embodiment. The semiconductor structure is described below by using a DRAM as an example, but this embodiment is not limited thereto. Alternatively, the semiconductor structure in this embodiment may further be another structure.

As shown in FIG. 8, an exemplary embodiment of the present disclosure provides a method of manufacturing a semiconductor structure, including:
Step S110: Provide a substrate.

With reference to FIG. 11, the substrate 10 may be made of a semiconductor material. The semiconductor material may be one or more selected from the group consisting of silicon, germanium, a silicon germanium compound, and a silicon carbon compound. The semiconductor material may be an intrinsic semiconductor material or a semiconductor dopant material that is lightly doped with ions.

Step S120: Perform first etching on the substrate, to form a plurality of first trenches that extend along a first direction and are disposed at intervals in a direction perpendicular to the first direction.

As shown in FIG. 11, the substrate 10 is partially removed through the first etching, that is, the substrate 10 is etched for the first time, to form the plurality of first trenches 11 therein. Each first trench 11 extends along the first direction D1, and the plurality of first trenches 11 are disposed at intervals in a third direction D3 perpendicular to the first direction D1.

Step S130: Perform second etching on the substrate, to form a plurality of second trenches that extend along a second direction and are disposed at intervals in a direction perpendicular to the second direction, where the first direction and the second direction form a predetermined angle, and the predetermined angle is an acute angle or an obtuse angle.

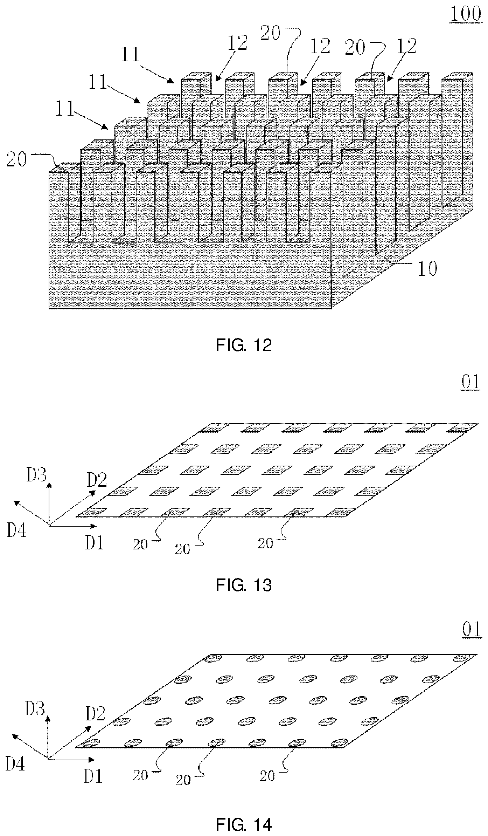

As shown in FIG. 12, with reference to FIG. 11, second etching is performed on the substrate 10, that is, the substrate 10 is etched for a second time. The etching process specifically includes: the substrate 10 is partially removed through the second etching, to form a plurality of second trenches 12. Each second trench 12 extends along a second direction D2. The plurality of second trenches 12 are disposed at intervals along a fourth direction D4 perpendicular to the second direction D2. The plurality of first trenches 11 are disposed in parallel along the first direction D1. The plurality of second trenches 12 are disposed in parallel along the second direction D2. The plurality of first trenches 11 and the plurality of second trenches 11 intersect at a predetermined angle. The remaining structure on the substrate 10 is divided into a plurality of active pillars 20 independent of each other. The plurality of active pillars 20 form a quadrilateral array along the first direction D1 and the second direction D2.

In this embodiment, as shown in FIGS. 12 and 13, the active pillars 20 are prismatic.

For example, the angle between the first direction D1 and the second direction D2 may be 30°, 35°, 45°, 55°, 65° or 70°, or may be 110° to 150° such as 110°, 120°, 130°, 140° or 150°.

In this embodiment, the angle between the first direction D1 and the second direction D2 is 60° or 120°. The first trenches 11 and the second trenches 12 in this embodiment intersect to divide the substrate 10 into more active pillars 20. A plurality of active pillars 20 are in a hexagonal close-packed arrangement, such that a largest quantity of active pillars 20 are formed per unit area, with a largest arrangement density.

In an embodiment, the first trench 11 is as wide as the second trench 12. A spacing between adjacent active pillars 20 in the first direction D1 and that in the second direction D2 are equal. The active pillar 20 formed in this embodiment is a rhombus pillar with four sides of an equal length, such that the active pillar 20 occupies a smallest space of the semiconductor structure, to further improve the space utilization of the semiconductor structure. The quantity of active pillars disposed on the semiconductor structure in this embodiment is the largest, with a largest arrangement density.

In other embodiments, the spacing between two adjacent active pillars 20 in the first direction D1 may be greater or smaller than that between two adjacent active pillars 20 in the second direction D2.

In this embodiment, with reference to FIG. 12, the first trench 11 is deeper or shallower than the second trench 12. In the subsequent manufacturing process, the bit line 40 is formed in a deeper one of the first trench 11 and the second trench 12, and the word line 50 is formed in the other one. In some embodiments, if the first trench 11 is deeper than the second trench 12, the bit line 40 is formed in the first trench 11, and the word line 50 is formed in the second trench 12.

By using the method in this embodiment, a plurality of first trenches and a plurality of second trenches are formed in a non-orthogonal arrangement, to divide the substrate into a plurality of active pillars disposed independently, and make the active pillars arranged denser, improving the space utilization of the semiconductor structure.

According to an exemplary embodiment, the method of manufacturing a semiconductor structure in this embodiment further includes:
Step S140: Oxidize the active pillar, such that the active pillar changes from the prismatic shape to a cylindrical or elliptical cylinder shape.

In this step, when the active pillar 20 is oxidized, four corners of the prismatic active pillar 20 are partially oxidized at a faster rate, and the middle part between any two corners is oxidized at a slower rate, thereby oxidizing four corners of the active pillar 20 into chamfers (with reference to FIGS. 13 and 14). Therefore, the active pillar changes from the prismatic shape to a cylindrical or elliptical cylinder shape. An oxide layer is formed on a sidewall of the sidewall 20 through the oxidation. To prevent the oxide layer from affecting the conductivity of the active pillar 20, after the oxidation, the oxide layer on the sidewall of the active pillar 20 is removed through dry or wet etching, to ensure a favorable electrical performance of the active pillar 20.

In this embodiment, a thermal oxidation process may be used to oxidize the active pillar 20. The semiconductor structure is placed in a reaction chamber with a temperature of 600°C to 1000°C. Oxygen is introduced into the reaction chamber. The treatment time is 60 to 300 seconds. After the thermal oxidation treatment, the active pillar 20 is cleaned with an acid solution to remove the oxide layer on the surface of the active pillar 20.

As shown in FIG. 12, after the processing step of this embodiment, a plurality of active pillars 20 arranged independently are formed on the substrate 10. The plurality of active pillars 20 are arranged in a parallelogram array along the first direction D1 and the second direction D2. Any two adjacent ones of the plurality of active pillars 20 are separated by the first trench 11 or the second trench 12. The semiconductor structure formed in this embodiment is used as a first structure 100.

In the method in this embodiment, oxidizing the active pillar can repair the defects formed on the surface of the active pillar during the first etching and the second etching, that is, reduce the defects on the surfaces of the first trench and the second trench, and reduces a stress between the isolation structure formed subsequently and the active pillar, to make the subsequently formed isolation structure have a better isolation effect, thereby preventing current leakage from occurring to the members in the semiconductor structure.

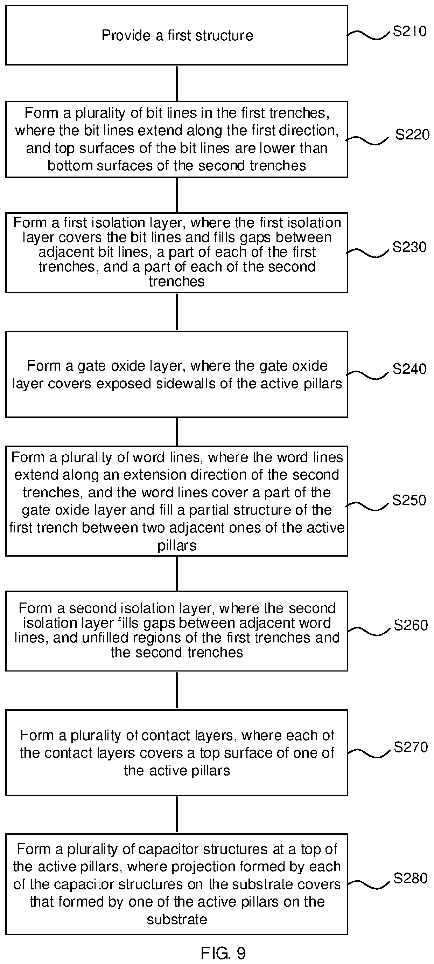

An exemplary embodiment of the present disclosure provides a method of manufacturing a semiconductor structure, as shown in FIG. 9. FIG. 9 is a flowchart of a method of manufacturing a semiconductor structure according to an exemplary embodiment of the present disclosure. FIGS. 12 to 25 are schematic diagrams of the method of manufacturing a semiconductor structure at various stages. The method of manufacturing a semiconductor structure is described below with reference to FIGS. 12 to 25.

The semiconductor structure is not limited in this embodiment. The semiconductor structure is described below by using a DRAM as an example, but this embodiment is not limited thereto. Alternatively, the semiconductor structure in this embodiment may further be another structure.

As shown in FIG. 9, an exemplary embodiment of the present disclosure provides a method of manufacturing a semiconductor structure, including:
S210: Provide a first structure.

A first structure 100 in this embodiment is formed by in the foregoing embodiment. As shown in FIG. 12, the first structure 100 includes a plurality of active pillars 20. Any two adjacent ones of the plurality of active pillars 20 are separated by a first trench 11 or a second trench 12. The first trench 11 and the second trench 12 intersect at a predetermined angle, and the predetermined angle is an acute angle or an obtuse angle. The plurality of active pillars 20 are arranged in a parallelogram array.

S220: Form a plurality of bit lines in the first trenches, where the bit lines extend along the first direction, and top surfaces of the bit lines are lower than bottom surfaces of the second trenches.

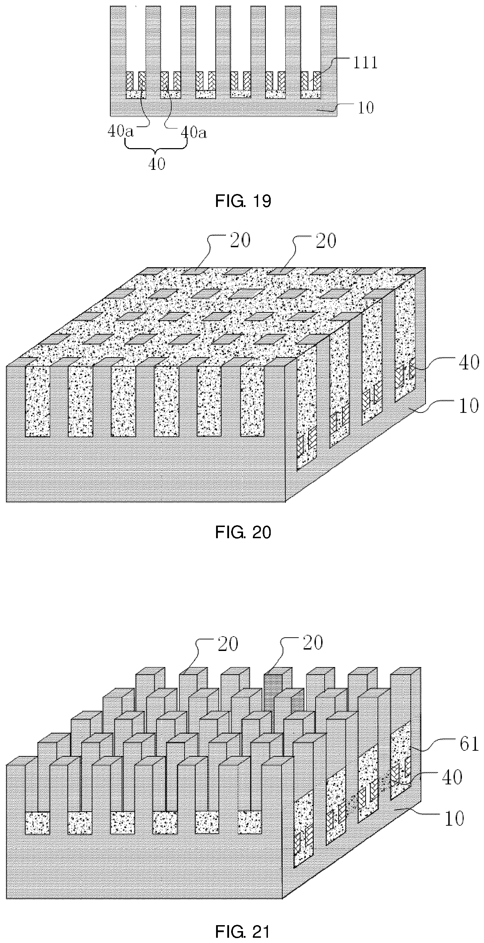

As shown in FIG. 20, with reference to FIG. 12, the bit lines 40 are formed in the first trenches 11. The bit lines 40 extend along the first direction D1 and are disposed below a row of the active pillars 20 arranged along the first direction D1.

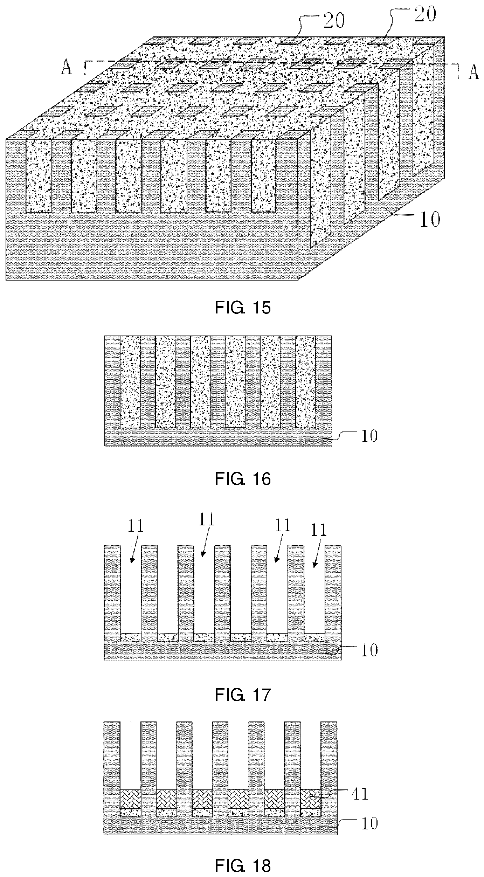

In an example, as shown in FIGS. 15 and 16, forming the bit lines 10 in the first trenches 11 includes the following process:
An isolation material is deposited in the first trenches 11 and the second trenches 12. As shown in FIG. 17, the isolation material in the first trenches 11 is etched back by a predetermined depth. The predetermined depth is greater than a depth of the second trench 12 and smaller than a depth of the first trench 11. As shown in FIG. 18, with reference to FIG. 12, a conductive material is deposited to form an initial bit line layer 41 in the first trenches 11, and the top surface of the initial bit line layer is lower than the bottom surfaces of the second trenches 12. As shown in FIG. 19, the initial bit line layer 41 is removed through etching. A first gap 111 extending along the first direction 11 is formed in each of the first trenches 11. The remaining part of the initial bit line layer 41 is divided by the first gaps 111 into a plurality of bit lines 40. The initial bit line layer 41 located in each of the first trenches 11 is divided by the first gap 111 into bit line layers 40a disposed on both sidewalls of the first trench 11. Each bit line 40 is connected to a row of the active pillars 20 extending along the first direction D1. Each bit line 40 includes two bit line layers 40a disposed at two sides of each row of the active pillars 20. The two bit line layers 40a of each bit line 40 are disposed in two adjacent first trenches 11.

S230: Form a first isolation layer, where the first isolation layer covers the bit lines and fills gaps between adjacent bit lines, a part of each of the first trenches, and a part of each of the second trenches.

As shown in FIG. 20, with reference to FIG. 19, an isolation material is deposited to fill the gap between two adjacent bit lines 40. As shown in FIG. 21, with reference to FIG. 20, the isolation material in the first trenches 11 and the second trenches 12 is etched back by a depth that is not bigger than a depth of the second trench 12. The remaining part of the isolation material forms a first isolation layer 61.

S240: Form a gate oxide layer, where the gate oxide layer covers exposed sidewalls of the active pillars.

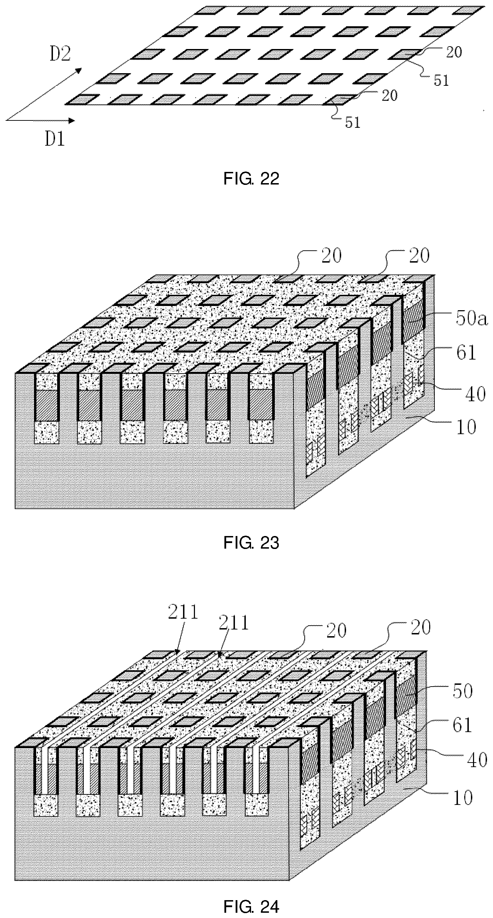

As shown in FIG. 22, with reference to FIGS. 13 and 21, an atomic layer deposition (ALD) process or a chemical vapor deposition (CVD) process may be used for deposition to form the gate oxide layer 51. The gate oxide layer 51 covers the sidewalls of the active pillars 20 exposed by the first trenches 11 and the second trenches 12. The gate oxide layer 51 may be made of a dielectric material such as silicon oxide and/or silicon oxynitride.

S250: Form a plurality of word lines, where the word lines extend along an extension direction of the second trenches, and the word lines cover a part of the gate oxide layer and fill a partial structure of the first trench between two adjacent ones of the active pillars.

As shown in FIG. 23, with reference to FIGS. 21 and 22, the process of forming the plurality of word lines 50 includes:
The ALD process or the CVD process may be used to deposit a word line material. The word line material fills the first trenches 11 and the second trenches 12 to form an initial word line layer 50a. The initial word line layer 50a is etched back until its top surface is lower than the top surfaces of the active pillars 20. Then, the isolation material is deposited to cover the initial word line layer 50a. A mask is provided. As shown in FIG. 24, the isolation material covering the initial word line layer 50a and the initial word line layer 50a are partially removed according to the mask, to form a second gap 211 extending along a second direction D2 in each of the second trenches 12. The remaining part of the initial word line layer 50a is separated by the second gaps 211 to form a plurality of word lines 50 arranged independently. As shown in FIG. 24, with reference to FIG. 2, each word line 50 partially covers sidewalls of a column of the active pillars 20 arranged along the second direction D2. The plurality of word lines 50 correspondingly cover sidewalls of a plurality of columns of the active pillars 20 along the second direction D2 respectively.

A material of the word line 50 includes one or more selected from the group consisting of conductive metal, conductive metal nitride, and conductive alloy. For example, the material of the conductive metal may be titanium, tantalum, or tungsten.

In this embodiment, the initial word line layer 50a is etched back to be lower than the active pillars 20. Then, the isolation material is deposited to cover the top surface of the initial word line layer 50a, to prevent the material forming the word line 50 from being oxidized by air, improving the electrical property of the formed word line 50.

S260: Form a second isolation layer, where the second isolation layer fills gaps between adjacent word lines, and unfilled regions of the first trenches and the second trenches.

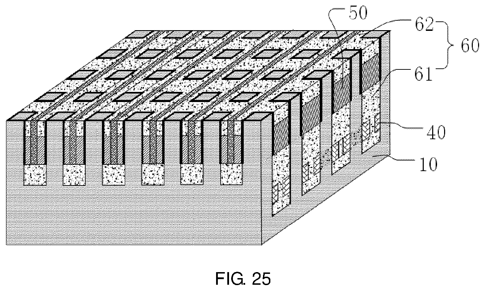

As shown in FIG. 25, with reference to FIG. 24, an isolation material is deposited to fill the second gaps 211. The isolation material in the second gaps 211 and the isolation material covering the top surfaces of the word lines 50 form the second isolation layer 62. The first isolation layer 61 and the second isolation layer 62 form an isolation structure 60.

S270: Form a plurality of contact layers, where each of the contact layers covers a top surface of one of the active pillars.

As shown in FIG. 5, with reference to FIG. 25, a plurality of contact layers 71 are correspondingly disposed on the active pillars 20. Each of the contact layers 71 is correspondingly disposed on the top surface of one of the active pillars 20. Each of the contact layers 71 is configured to form a capacitor structure 70 in the subsequent manufacturing process.

Step S280: Form a plurality of capacitor structures at a top of the active pillars, where projection formed by each of the capacitor structures on the substrate covers that formed by one of the active pillars on the substrate.

As shown in FIG. 5, a capacitor structure 70 is correspondingly formed on each of the contact layers 71. Each capacitor structure 70 is correspondingly disposed on one active pillar 20. The capacitive structure 70 is connected to the active pillar 20 through the contact layer 71. In this embodiment, after the capacitor structures 70 are formed, a silicon germanium compound is deposited to fill a gap between the capacitor structures 70.

As shown in FIG. 5, after the processing steps of this embodiment, the plurality of bit lines 40 extending along the first direction D1, the plurality of word lines 50 extending along the second direction D2, the isolation structure 60, the contact layer 71, and the plurality of capacitor structures 70 corresponding to the plurality of active pillars 20 respectively are formed on the first structure 100. The semiconductor structure formed in this embodiment is used as a second structure 200.

In the semiconductor structure formed in this embodiment, the capacitor structure and active pillars are formed in a same parallelogram array, to improve the packing density of the capacitor structure per unit area, and improve the storage capacity of the semiconductor structure, which can further meet the integration development of the semiconductor structure, and is especially beneficial to miniaturing the size of a gate-all-around (GAA) semiconductor structure.

According to an exemplary embodiment, when the angle between the first direction D1 and the second direction D2 is 60° or 120°, the semiconductor structure formed in this embodiment has more capacitor structures 70 per unit area, the capacitor structures 70 are in a hexagonal closest-packed arrangement, and the capacitor structures 70 are arranged most densely.

An exemplary embodiment of the present disclosure provides a method of manufacturing a semiconductor structure, as shown in FIG. 10. FIG. 10 is a flowchart of a method of manufacturing a semiconductor structure according to an exemplary embodiment of the present disclosure. The method of manufacturing a semiconductor structure is described below with reference to FIGS. 5 to 7.

The semiconductor structure is not limited in this embodiment. Description is made by using the semiconductor structure as a memory chip, but this embodiment is not limited thereto, and the semiconductor structure in this embodiment may further be another structure.

As shown in FIG. 10, an exemplary embodiment of the present disclosure provides a method of manufacturing a semiconductor structure, including:
Step S310: Provide a second structure.

As shown in FIGS. 5 and 6, the second structure 200 of this embodiment is formed in the foregoing embodiment. The second structure 20 has an outer contour of a parallelogram.

Step S320: Form a core circuit region, where the core circuit region includes a sense amplification circuit region and a word line driving circuit region.

In this embodiment, when the core circuit region 80 is formed, a sense amplification circuit region 81 extending along the second direction D2 is formed first. A plurality of sense amplifiers 810 arranged along the second direction D2 are formed in the sense amplification circuit region 81. The sense amplifier 810 is connected to the bit line 40.

As shown in FIG. 7, forming the core circuit region 80 further includes: forming a word line driving circuit region 82 extending along the first direction D1, where a plurality of word line drivers 820 arranged along the first direction D1 are disposed in the word line driving circuit region 82, and the word line driver 820 is connected to the word line 50.

In this embodiment, the core circuit region 80 is arranged according to the arrangement direction of the bit lines 40 and the word lines 50, which can prevent the core circuit region 80 disposed in this manner from damaging the active pillars 20 in the second structure 200.

Step S330: Form a peripheral circuit region outside the core circuit region, where the peripheral circuit region has a contour extending along the first direction and the second direction.

As shown in FIG. 7, a peripheral circuit 910 or peripheral member 920 in the peripheral circuit region 90 is electrically connected to a circuit or component in the core circuit region 80. The peripheral circuit region 90 is disposed along the outer contour of the second structure 200. The outer contour of the semiconductor structure formed in this embodiment and the second structure 200 are in a same parallelogram shape.

The semiconductor structure formed in this embodiment may be a memory chip, and the memory chip may be used in a DRAM. However, the memory structure may be further applied to a static random-access memory (SRAM), a flash memory (flash EPROM), a ferroelectric random-access memory (FRAM), a magnetic random-access memory (MRAM), a phase change random-access memory (PRAM), or the like.

In the method in this embodiment, a peripheral circuit region is formed along a contour edge of the second structure, and the outer contour of the formed semiconductor structure is a parallelogram, which omits the steps of cutting the semiconductor structure into regular squares or rectangles and shorten the production process. Therefore, each active pillar and each capacitor structure in the semiconductor structure are not damaged by the cutting, and the array region is fully used.

The embodiments or implementations of this specification are described in a progressive manner, and each embodiment focuses on differences from other embodiments. The same or similar parts between the embodiments may refer to each other.

In the description of the specification, the description with reference to terms such as "an embodiment", "an exemplary embodiment", "some implementations", "a schematic implementation", and "an example" means that the specific feature, structure, material, or characteristic described in combination with the implementation(s) or example(s) is included in at least one implementation or example of the present disclosure.

In this specification, the schematic expression of the above terms does not necessarily refer to the same implementation or example. Moreover, the described specific feature, structure, material or characteristic may be combined in an appropriate manner in any one or more implementations or examples.

It should be noted that in the description of the present disclosure, the terms such as "center", "top", "bottom", "left", "right", "vertical", "horizontal", "inner" and "outer" indicate the orientation or position relationships based on the drawings. These terms are merely intended to facilitate description of the present disclosure and simplify the description, rather than to indicate or imply that the mentioned apparatus or element must have a specific orientation and must be constructed and operated in a specific orientation. Therefore, these terms should not be construed as a limitation to the present disclosure.

It can be understood that the terms such as "first" and "second" used in the present disclosure can be used to describe various structures, but these structures are not limited by these terms. Instead, these terms are merely intended to distinguish one element from another.

The same elements in one or more drawings are denoted by similar reference numerals. For the sake of clarity, various parts in the drawings are not drawn to scale. In addition, some well-known parts may not be shown. For the sake of brevity, the structure obtained by implementing multiple steps may be shown in one figure. In order to make the understanding of the present disclosure more clearly, many specific details of the present disclosure, such as the structure, material, size, processing process, and technology of the device, are described below. However, as those skilled in the art can understand, the present disclosure may not be implemented according to these specific details.

Finally, it should be noted that the above embodiments are merely intended to explain the technical solutions of the present disclosure, rather than to limit the present disclosure. Although the present disclosure is described in detail with reference to the above embodiments, those skilled in the art should understand that they may still modify the technical solutions described in the above embodiments, or make equivalent substitutions of some or all of the technical features recorded therein, without deviating the essence of the corresponding technical solutions from the scope of the technical solutions of the embodiments of the present disclosure.

### Industrial Applicability

In a semiconductor structure and a manufacturing method thereof provided by embodiments of the present disclosure, a plurality of active pillars of the semiconductor structure are arranged in a parallelogram array, improving an arrangement density of the active pillars per unit area and a space utilization of the semiconductor structure.

## Claims

1. A semiconductor structure, comprising:
an array region, wherein the array region is provided with a plurality of active pillars;
a plurality of bit lines extending along a first direction, wherein the bit lines are located at bottoms of the active pillars; and
a plurality of word lines extending along a second direction, wherein any one of the plurality of word lines covers sidewalls of a column of the active pillars arranged along the second direction; and
the first direction and the second direction form a predetermined angle, and the predetermined angle is an acute angle or an obtuse angle.

2. The semiconductor structure according to claim 1, wherein the active pillar is in a prismatic, cylindrical, or elliptical cylinder shape.

3. The semiconductor structure according to claim 1, wherein the predetermined angle is 60° or 120°.

4. The semiconductor structure according to claim 1, further comprising:
a plurality of capacitor structures, wherein each of the capacitor structures is correspondingly disposed above one of the active pillars, and projection formed by each of the capacitor structures on the active pillars covers a top surface of one of the active pillars.

5. The semiconductor structure according to claim 4, further comprising:
an isolation structure, wherein the isolation structure fills gaps between adjacent active pillars, between adjacent word lines, between adjacent bit lines, between the word line and the bit line, and between the word line and the capacitor structure; and
a plurality of contact layers, wherein each of the contact layers covers a top surface of one of the active pillars, and the contact layers are disposed between the active pillars and the capacitor structures.

6. The semiconductor structure according to claim 1, further comprising:
a core circuit region, wherein the core circuit region is located on a periphery of the array region;
the core circuit region is provided with a sense amplification circuit region, a plurality of sense amplifiers arranged along the second direction are disposed in the sense amplification circuit region, and the sense amplifier is connected to the bit line; and
the core circuit region is further provided with a word line driving circuit region, a plurality of word line drivers arranged along the first direction are disposed in the word line driving circuit region, and the word line driver is connected to the word line.

7. The semiconductor structure according to claim 6, further comprising:
a peripheral circuit region, wherein the peripheral circuit region is located outside the core circuit region, a circuit or component in the peripheral circuit region is connected to a circuit or component in the core circuit region, and the peripheral circuit region has a contour extending along the first direction and the second direction.

8. A method of manufacturing a semiconductor structure, comprising:
providing a substrate;
performing first etching on the substrate, to form a plurality of first trenches that extend along a first direction and are disposed at intervals in a direction perpendicular to the first direction; and
performing second etching on the substrate, to form a plurality of second trenches that extend along a second direction and are disposed at intervals in a direction perpendicular to the second direction, wherein the first direction and the second direction form a predetermined angle, and the predetermined angle is an acute angle or an obtuse angle; and
the first trenches and the second trenches are interspersed to form a plurality of discrete active pillars, and a spacing between adjacent active pillars in the first direction is equal to a spacing between adjacent active pillars in a second direction.

9. The method of manufacturing a semiconductor structure according to claim 8, wherein the first trench is deeper than the second trench.

10. The method of manufacturing a semiconductor structure according to claim 9, further comprising:
forming a plurality of bit lines in the first trenches, wherein the bit lines extend along the first direction, and top surfaces of the bit lines are lower than bottom surfaces of the second trenches; and
forming a first isolation layer, wherein the first isolation layer covers the bit lines and fills gaps between adjacent bit lines, a part of each of the first trenches, and a part of each of the second trenches.

11. The method of manufacturing a semiconductor structure according to claim 10, further comprising:
forming a gate oxide layer, wherein the gate oxide layer covers exposed sidewalls of the active pillars;
forming a plurality of word lines, wherein the word lines extend along an extension direction of the second trenches, and the word lines cover a part of the gate oxide layer and fill a partial structure of the first trench between two adjacent ones of the active pillars; and
forming a second isolation layer, wherein the second isolation layer fills gaps between adjacent word lines, and unfilled regions of the first trenches and the second trenches.

12. The method of manufacturing a semiconductor structure according to claim 8, further comprising:
forming a plurality of contact layers, wherein each of the contact layers covers a top surface of one of the active pillars.

13. The method of manufacturing a semiconductor structure according to claim 8, further comprising:
forming a plurality of capacitor structures at a top of the active pillars, wherein projection formed by each of the capacitor structures on the substrate covers projection formed by one of the active pillars on the substrate.

14. The method of manufacturing a semiconductor structure according to claim 8, wherein the active pillar is in a prismatic shape, and the method further comprises:
oxidizing the active pillar, such that the active pillar changes from the prismatic shape to a cylindrical or elliptical cylinder shape.

15. The method of manufacturing a semiconductor structure according to claim 11, further comprising:
forming a core circuit region, wherein the core circuit region comprises a sense amplification circuit region and a word line driving circuit region;
wherein, a plurality of sense amplifiers arranged along the second direction are disposed in the sense amplification circuit region, and the sense amplifier is connected to the bit line; and
a plurality of word line drivers arranged along the first direction are disposed in the word line driving circuit region, and the word line driver is connected to the word line.

16. The method of manufacturing a semiconductor structure according to claim 15, further comprising:
forming a peripheral circuit region outside the core circuit region, wherein the peripheral circuit has a contour extending along the first direction and the second direction; and
a circuit or component in the peripheral circuit region is electrically connected to a circuit or component in the core circuit region.
